(19) Europäisches Patentamt / European Patent Office / Office européen des brevets

(11) EP 4 623 039 B1

(12) EUROPEAN PATENT SPECIFICATION

(45) Date of publication and mention of the grant of the patent:
**22.04.2026 Bulletin 2026/17**

(21) Application number: **23700758.8**

(22) Date of filing: **11.01.2023**

(51) International Patent Classification (IPC):
***C09K 5/14*** *(2006.01)* ***C08K 3/08*** *(2006.01)*
***H01L 23/373*** *(2006.01)* ***C08L 83/04*** *(2006.01)*
***H01L 23/42*** *(2006.01)* ***C09J 183/00*** *(2006.01)*

(52) Cooperative Patent Classification (CPC):
(C-Sets available)
**C09K 5/14; C08K 7/00; C08L 83/04; C09D 183/04; C09J 183/04;** C08K 2003/0806; C08K 2201/003; C08K 2201/006; H10W 40/251; H10W 40/70
(Cont.)

(86) International application number:
**PCT/EP2023/050569**

(87) International publication number:
**WO 2024/149457 (18.07.2024 Gazette 2024/29)**

(54) **SILICONE BASED RESIN COMPOSITION, AND SEMICONDUCTOR DEVICE COMPRISING THE SAME**

HARZZUSAMMENSETZUNG AUF SILIKONBASIS UND HALBLEITERBAUELEMENT DAMIT

COMPOSITION DE RÉSINE À BASE DE SILICONE ET DISPOSITIF À SEMI-CONDUCTEUR LA COMPRENANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**01.10.2025 Bulletin 2025/40**

(73) Proprietor: **Wacker Chemie AG**
**81671 München (DE)**

(72) Inventors:
- **CHOI, JongHak**
  **Seongnam-si Gyeonggi-do 13494 (KR)**
- **JOO, YoungHyuk**
  **Seongnam-si Gyeonggi-do 13494 (KR)**
- **KIM, TaeJoon**
  **Seongnam-si Gyeonggi-do 13494 (KR)**
- **LEE, JunGyu**
  **Seongnam-si Gyeonggi-do 13494 (KR)**

(74) Representative: **Mieskes, Klaus Theoderich et al**
**Wacker Chemie AG**
**Gisela-Stein-Straße 1**
**81671 München (DE)**

(56) References cited:
**WO-A1-2021/142752**
**US-A1- 2017 274 453**
**US-A1- 2021 284 803**
**US-A1- 2022 340 794**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08K 7/00, C08L 83/04;**
**C08L 83/04, C08L 83/00, C08K 5/56;**
**C08L 83/04, C08L 83/00, C08K 5/56, C08K 3/08, C08K 3/08, C08K 7/00;**
C08K 7/16, C08L 83/04;
C08K 7/18, C08L 83/04

## Description

[Technical Field]

The present invention relates to a silicone-based resin composition and a semiconductor device including the same.

[Background Art]

Since most electronic components generate heat during use thereof, it is necessary to remove heat from the electronic components for the proper operation thereof. In particular, in integrated circuit elements such as CPUs used in personal computers, the amount of heat dissipated is increasing due to an increase in operating frequency, whereby countermeasures against heat have emerged as an important issue.

Accordingly, many methods of dissipating such heat have been proposed, and in electronic components dissipating a large amount of heat, a method of dissipating heat by interposing a thermally conductive material, such as thermally conductive grease or a thermally conductive sheet, between an electronic component and a member such as a heat sink has been proposed. Korean Patent Application Publication No. 10-2020-0086307 discloses a semiconductor device including a thermally conductive material. WO 2021/142752 A1 discloses further thermally conductive materials.

However, in the case of thermally conductive materials prepared by pressurizing a thermally conductive composition, thermal conductivity characteristics are expressed differently depending on pressurization conditions even if the same thermally conductive composition is used, resulting in a decrease in the reliability of product performance.

[Related Art Document]

[Patent Document]

(Patent Document 1) Korean Patent Application Publication No. 10-2020-0086307

[Disclosure]

[Technical Problem]

Therefore, the present invention has been made in view of the above problems, and it is one object of the present invention to provide a silicone-based resin composition having minimized thermal conductivity variation and excellent heat dissipation and durability and a semiconductor device including the silicone-based resin composition.

[Technical Solution]

In accordance with an aspect of the present invention, there is provided a silicone-based resin composition, including: an organic polysiloxane; and a conductive filler, wherein the conductive filler comprises a first conductive powder comprising dendrite-type particles and a second conductive powder comprising spherical particles, wherein the first conductive powder and the second conductive powder in a weight ratio of 5:95 to 50:50, wherein the first conductive powder comprises silver powder surface-treated with a C10 to C20 fatty acid, and wherein the silicone-based resin composition has a thermal conductivity change rate of 30% or less as measured by Measurement method below:

[Measurement method]

1) the silicone-based resin composition is molded by hot press for 15 minutes under conditions of 165°C and a pressure of 26 kgf/cm$^2$ to manufacture a first sheet, and separately, the silicone-based resin composition is molded by hot press for 15 minutes under conditions of 165°C and a pressure of 0.1 kgf/cm$^2$ to manufacture a second sheet.
2) the first sheet and the second sheet are cured at 150°C for 2 hours to respectively manufacture a sample of the first sheet and a sample of the second sheet.
3) a thermal conductivity of the first sheet sample and a thermal conductivity of the second sheet sample are measured at 25°C according to ISO 22007-2.
4) a thermal conductivity change rate is calculated according to Equation 2 below:

[Equation 2]

$$\text{Thermal conductivity change rate (\%)} = (\left| TC_{26} - TC_{0.1} \right| / TC_{26}) \times 100$$

where $TC_{26}$ is a thermal conductivity (W/mK) of the first sheet sample, and $TC_{0.1}$ is a thermal conductivity (W/mK) of the second sheet sample.

In an embodiment of the present invention, the silicone-based resin composition may include the organic polysiloxane and the conductive filler in a weight ratio of 20:80 to 5:95.

In an embodiment of the present invention, the first conductive powder may have a tap density of 0.1 g/cm$^3$ to 3.0 g/cm$^3$.

In an embodiment of the present invention, the first conductive powder may have a specific surface area of 0.2 m$^2$/g to 5.0 m$^2$/g.

In an embodiment of the present invention, the silicone-based resin composition may have a thermal conductivity per filler weight of 1 W/mK or more calculated by Equation 3 below:

[Equation 3]

$$X/Y \times 10$$

where X is a thermal conductivity, measured at 25°C, of the first sheet sample or the second sheet sample, and, Y is weight% of the conductive filler based on a total weight of the silicone-based resin composition.

In an embodiment of the present invention, the first sheet sample or the second sheet sample may have a thermal conductivity of 10 W/mK or more measured at 25°C.

In accordance with another aspect of the present invention, there is provided a semiconductor device, including: a semiconductor package; a heat dissipation part disposed on the semiconductor package; and a heat conduction layer interposed between the semiconductor package and the heat dissipation part, wherein the heat conduction layer includes a silicone-based resin composition, wherein the silicone-based resin composition includes an organic polysiloxane and a conductive filler, wherein the conductive filler comprises a first conductive powder comprising dendrite-type particles and a second conductive powder comprising spherical particles, wherein the first conductive powder and the second conductive powder in a weight ratio of 5:95 to 50:50, wherein the first conductive powder comprises silver powder surface-treated with a C10 to C20 fatty acid, and the silicone-based resin composition has a thermal conductivity change rate of 30% or less measured by Measurement method below:

[Measurement method]

1) the silicone-based resin composition is molded by hot press for 15 minutes under conditions of 165°C and a pressure of 26 kgf/cm$^2$ to manufacture a first sheet, and separately, the silicone-based resin composition is molded by hot press for 15 minutes under conditions of 165°C and a pressure of 0.1 kgf/cm$^2$ to manufacture a second sheet.
2) the first sheet and the second sheet are cured at 150°C for 2 hours to respectively manufacture a sample of the first sheet and a sample of the second sheet.
3) a thermal conductivity of the first sheet sample and a thermal conductivity of the second sheet sample are measured at 25°C according to ISO 22007-2.
4) a thermal conductivity change rate is calculated according to Equation 2 below:

[Equation 2]

$$\text{Thermal conductivity change rate (\%)} = (\left| TC_{26} - TC_{0.1} \right| / TC_{26}) \times 100$$

where $TC_{26}$ is a thermal conductivity (W/mK) of the first sheet sample, and $TC_{0.1}$ is a thermal conductivity (W/mK) of the second sheet sample.

[Advantageous effects]

A silicone-based resin composition of the present invention exhibits a thermal conductivity value capable of

performing an appropriate heat dissipation function even when commercialized under different pressure conditions and can improve the reliability of product performance due to a small thermal conductivity variation.

In addition, a conductive filler has a uniform average particle diameter and includes conductive particles with different shapes in a specific content ratio, thereby being capable of improving the formation of an electrical network between the particles, so that the silicone-based resin composition exhibits high thermal conductivity even when the conductive filler is included in a low content.

Further, since an organic polysiloxane and a conductive filler are included in a specific content ratio, proper adhesion to an adherend can be maintained, and voids and cracks due to thermal shock do not occur, resulting in excellent durability.

[Description of Drawings]

FIG. 1 sequentially illustrates a method of measuring the thermal conductivity of a silicone-based resin composition according to the present invention.

FIG. 2 schematically illustrates a semiconductor device according to the present invention.

[Best mode]

Structural or functional descriptions of the embodiments disclosed in this specification or application are merely exemplified for the purpose of explaining embodiments according to the technical idea of the present invention, embodiments according to the technical idea of the present invention may be implemented in various forms other than the embodiments disclosed in this specification or application, and it is not to be construed that the technical idea of the present invention is limited to the embodiments described in this specification or application.

In addition, when a component is "included" or "comprised" in this specification or application, other components may be further included or comprised, rather than excluding other components, unless otherwise stated. In addition, it should be understood that all numerical ranges representing the physical property values, dimensions, etc. of components described in this specification or application are modified by the term "about" in all cases unless otherwise specified.

Hereinafter, a silicone-based resin composition according to the present invention, and a semiconductor device including the the silicone-based resin composition are described.

<Silicone-based resin composition>

The silicone-based resin composition according to the present invention includes an organic polysiloxane and a conductive filler and has a thermal conductivity change rate of 30% or less as measured by the following measurement method.

[Measurement method]

1) The silicone-based resin composition was molded by hot press for 15 minutes under conditions of 165°C and a pressure of 26 kgf/cm$^2$ to manufacture a first sheet, and separately, the silicone-based resin composition was molded by hot press for 15 minutes under conditions of 165°C and a pressure of 0.1 kgf/cm$^2$ to manufacture a second sheet.
2) The first sheet and the second sheet were cured at 150°C for 2 hours to respectively manufacture a sample of the first sheet and a sample of the second sheet.
3) A thermal conductivity of the first sheet sample and a thermal conductivity of the second sheet sample were measured at 25°C according to ISO 22007-2.
4) The thermal conductivity change rate was calculated according to Equation 2 below:

[Equation 2]

$$\text{Thermal conductivity change rate (\%)} = (\left| TC_{26} - TC_{0.1} \right| / TC_{26}) \times 100$$

(where $TC_{26}$ is a thermal conductivity (W/mK) of the first sheet sample, and $TC_{0.1}$ is a thermal conductivity (W/mK) of the second sheet sample.)

The silicone-based resin composition includes an organic polysiloxane.

The organic polysiloxane may be represented by Formula 1 below:

[Formula 1] $R^1{}_aSiO_b$

where $R^1$ represents one or two or more groups selected from the group consisting of a hydrogen atom, a hydroxyl group, and a saturated or unsaturated monovalent hydrocarbon group having 1 to 18 carbon atoms and a may be about 1.8 to about 2.2. a+b may be about 3.5 to about 8.
a+b may be 4.

In Formula 1, the saturated or unsaturated monovalent hydrocarbon group having 1 to 18 carbon atoms represented by $R^1$ may be, for example, an alkyl group such as a methyl group, an ethyl group, a propyl group, a hexyl group, an octyl group, a decyl group, a dodecyl group, a tetradecyl group, a hexadecyl group, or an octadecyl group; a cycloalkyl group such as a cyclopentyl group or a cyclohexyl group; an alkenyl group such as a vinyl group or an allyl group; an aryl group such as a phenyl group or a tolyl group; an aralkyl group such as a 2-phenylethyl group or a 2-methyl-2-phenylethyl group; or a halogenated hydrocarbon group such as a 3,3,3-trifluoropropyl group, a 2-(perfluorobutyl)ethyl group, a 2-(perfluorooctyl)ethyl group, or a p-chlorophenyl group.

The organic polysiloxane may have a weight average molecular weight of about 40,000 g/mol to about 80,000 g/mol, about 30,000 g/mol to about 100,000 g/mol, about 500 g/mol to about 10,000 g/mol, about 700 g/mol to about 7,000 g/mol, about 1,000 g/mol to about 5,000 g/mol, or about 1,500 g/mol to about 3,000 g/mol. The weight average molecular weight may be measured based on polystyrene.

In the organic polysiloxane, a kinematic viscosity at 25°C may be 10 $mm^2/s$ to 100,000 $mm^2/s$, 20,000 $mm^2/s$ to 100,000 $mm^2/s$, or about 30 $mm^2/s$ to about 10,000 $mm^2/s$. The kinematic viscosity of the organic polysiloxane may be a value at 25°C measured with an Ostwald viscometer.

When the organic polysiloxane has a weight average molecular weight and kinematic viscosity within the above ranges, proper bonding strength to an adherend may be maintained, and durability may be improved because voids and cracks due to thermal shock do not occur.

The organic polysiloxane may include a first organic polysiloxane.

The first organic polysiloxane includes an alkenyl group bonded to a silicon atom, and the number of the alkenyl groups present in one molecule of the first organic polysiloxane may be at least two, two to ten, two to five, or two.

The first organic polysiloxane may be represented by Formula 2 below:

[Formula 2] $R^1{}_aR^2{}_cSiO_b$

where $R^1$ may be a hydrogen atom, a hydroxyl group, or a saturated or unsaturated monovalent hydrocarbon group having 1 to 18 carbon atoms, and $R^2$ may be an alkenyl group. In Formula 2, a+c may be about 1.8 to about 2.2, and a+b+c may be about 3.5 to about 8. In Formula 2, a+b+c may be about 4. In Formula 2, a may be about 1.8 to about 2.2. In addition, c may be 0.0001 to 0.1.

The first organic polysiloxane may be represented by Formula 3 below:

[Formula 3]

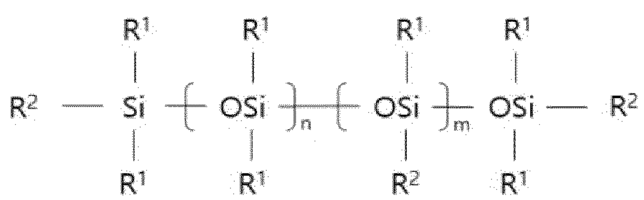

where $R^1$ may be a hydrogen atom, a hydroxyl group, or a saturated or unsaturated monovalent hydrocarbon group having 1 to 18 carbon atoms, $R^2$ may be an alkenyl group. In addition, in Formula 3, n may be 1 to 1,500, and m may be 0 to 20. In Formula 3, n may be 10 to 1,000, and m may be 0 to 20.

The first organic polysiloxane may be represented by Formula 4 below:

[Formula 4]

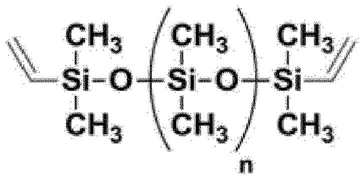

where n may be 1 to 1,500. n may be 10 to 1,000.

The first organic polysiloxane may have a weight average molecular weight (Mw) of about 500 g/mol to about 10,000 g/mol, about 700 g/mol to about 7,000 g/mol, about 1,000 g/mol to about 5,000 g/mol, or about 1,500 g/mol to about 3,000 g/mol. The weight average molecular weight may be measured based on polystyrene.

In the first organic polysiloxane, a kinematic viscosity at 23°C may be 10 cPs to 100,000 cPs, 30 cPs to 50,000 cPs, or 10,000 cPs to 40,000 cPs. The kinematic viscosity of the first organic polysiloxane may be a value at 25°C measured with an Ostwald viscometer.

The organic polysiloxane may include a second organic polysiloxane.

The second organic polysiloxane may include a hydrogen group bonded to a silicon atom. The number of the hydrogen groups per molecule of the second organic polysiloxane may be 1 to 10, 2 to 10, 2 to 5, or 2.

The second organic polysiloxane may be represented by Formula 5 below:

[Formula 5]

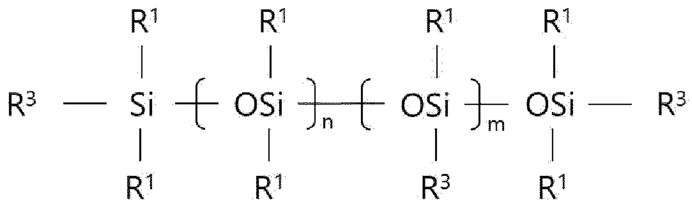

where $R^1$ may be a hydrogen atom, a hydroxyl group, or a saturated or unsaturated monovalent hydrocarbon group having 1 to 18 carbon atoms, and $R^3$ may be a hydrogen atom. In addition, in Formula 5, n may be 1 to 1,500, and m may be 0 to 20. In Formula 5, n may be 10 to 1,000, and m may be 0 to 20. In Formula 5, n may be 1 to 1,500, and m may be 0.

The second organic polysiloxane may be represented by Formula 6 below:

[Formula 6]

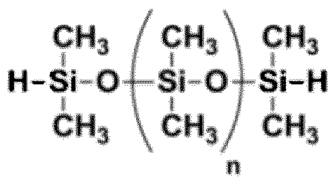

At about 23°C, the second organic polysiloxane may have a viscosity of about 500 cPs to about 5,000 cPs, about 500 cPs to about 3,000 cPs, or about 500 cPs to about 2,000 cPs.

The organic polysiloxane may further include a third organic polysiloxane. The third organic polysiloxane may be represented by Formula 7 below:

[Formula 7]

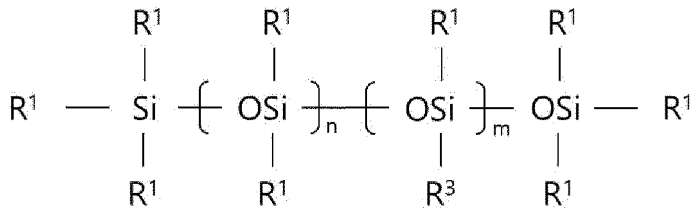

where $R^1$ may be a hydrogen atom, a hydroxyl group, or a saturated or unsaturated monovalent hydrocarbon group having 1 to 18 carbon atoms, $R^3$ may be a hydrogen atom. In addition, in Formula 7, n may be 1 to 1,500 and m may be 1 to 500. In Formula 7, n may be 10 to 1,000 and m may be 1 to 100.

The third organic polysiloxane may be represented by Formula 8 below:

[Formula 8]

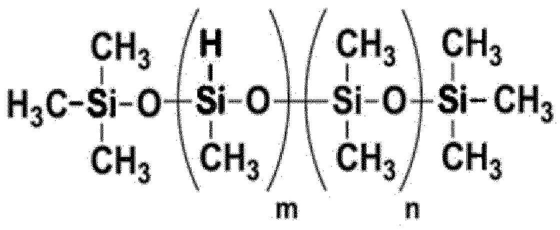

where n may be 1 to 1,500 and m may be 1 to 500. In Formula 8, n may be 10 to 1,000 and m may be 1 to 100.

At about 23°C, the third organic polysiloxane may have a viscosity of about 50 cPs to about 1,000 cPs, about 100 cPs to about 500 cPs, or about 100 cPs to about 500 cPs.

A ratio of the viscosity of the first organic polysiloxane to the viscosity of the second organic polysiloxane may be 10:1 to 40:1.

In addition, a ratio of the viscosity of the second organic polysiloxane to the viscosity of the third organic polysiloxane may be 2:1 to 10:1.

The content of the first organic polysiloxane may be about 60 parts by weight to about 90 parts by weight, about 70 parts by weight to about 85 parts by weight, or about 75 parts by weight to about 85 parts by weight based on 100 parts by weight of the total organic polysiloxane.

The content of the second organic polysiloxane may be about 10 parts by weight to about 40 parts by weight, about 10 parts by weight to about 30 parts by weight, or about 12 parts by weight to about 23 parts by weight based on 100 parts by weight of the first organic polysiloxane.

The content of the third organic polysiloxane may be about 3 parts by weight to about 20 parts by weight, about 3 parts by weight to about 15 parts by weight, or about 4 parts by weight to about 10 parts by weight based on 100 parts by weight of the first organic polysiloxane.

When the silicone-based resin composition includes the first organic polysiloxane, the second organic polysiloxane and the third organic polysiloxane within the above ranges, proper adhesion to an adherend may be maintained and the silicone-based resin composition may evenly spread during a coating process.

The silicone-based resin composition includes a conductive filler.

The conductive filler includes a first conductive powder including dendrite-type particles and a second conductive powder including spherical particles. The first silver powder includes surface-treated dendrite-type silver particles. The first silver powder may include dendrite-type silver particles coated with copper.

The first conductive powder may have a tap density of 0.1 $g/cm^3$ to 3.0 $g/cm^3$, 0.1 $g/cm^3$ to 2.0 $g/cm^3$, 0.1 $g/cm^3$ to 1.8 $g/cm^3$, 0.1 $g/cm^3$ to 1.6 $g/cm^3$, 0.2 $g/cm^3$ to 1.6 $g/cm^3$, 0.3 $g/cm^3$ to 1.6 $g/cm^3$, or 0.4 $g/cm^3$ to 1.6 $g/cm^3$.

To obtain the tap density, 100 g of silver powder is weighed and lightly dropped into a 100 ml measuring cylinder with a funnel, and then the measuring cylinder is placed on a tap density measuring device and the silver powder is compressed by dropping 600 times at a rate of 60 times/min from a fall distance of 20 mm. The tap density may be calculated from the volume of the compressed powder.

The first conductive powder may have a specific surface area of 0.2 $m^2/g$ to 5.0 $m^2/g$, 0.3 $m^2/g$ to 5.0 $m^2/g$, 0.4 $m^2/g$ to 5.0 $m^2/g$, 0.5 $m^2/g$ to 5.0 $m^2/g$, 0.7 $m^2/g$ to 5.0 $m^2/g$, 0.9 $m^2/g$ to 5.0 $m^2/g$, 1.0 $m^2/g$ to 5.0 $m^2/g$, 1.2 $m^2/g$ to 5.0 $m^2/g$,

1.4 $m^2/g$ to 5.0 $m^2/g$, 1.4 $m^2/g$ to 4.8 $m^2/g$, or 1.4 $m^2/g$ to 4.5 $m^2/g$.

To obtain the specific surface area, about 2 g of silver powder is taken as a sample, and after degassing at 60 ±5°C for 10 minutes, a total surface area is measured with an automatic specific surface area measuring device (BET method). The amount of the sample is weighed and the specific surface area is calculated according to the following equation.

Specific surface area ($m^2/g$) = total surface area ($m^2$)/sample amount (g)

An aspect ratio of the dendrite-type silver particles included in the first silver powder may be about 2 to 30, about 5 to 30, about 5 to 25, or about 5 to 20.

The first silver powder is surface-treated with a surface treatment agent. The surface treatment agent includes a C10 to C20 fatty acid. Examples of the fatty acid include capric acid, lauric acid, myristic acid, palmitic acid, stearic acid, arachidic acid, myristoleic acid, palmitolic acid, sapienic acid, oleic acid, elaidic acid, vaccenic acid, linoleic acid, linolelaidic acid, arachidonic acid, eicosapentaenoic acid, α-linolenic acid, and the like.

An ignition loss (Ig-loss) of the first silver powder may be less than about 0.8 wt%, less than about 0.7 wt%, or less than about 0.6 wt%. The ignition loss may be performed and measured for about 1 hour at about 538°C.

The surface of the first silver powder may be effectively treated even with a small amount of the surface treatment agent. That is, the first silver powder has a relatively low tap density and a large specific surface area, and may be surface-treated with a small amount of a surface treatment agent. Accordingly, the first silver powder may be uniformly dispersed in the organic polysiloxane and may improve thermal connection of the conductive filler. That is, since the first silver powder has improved dispersibility, the first silver powder may be added in a high content to the organic polysiloxane. In addition, since the first silver powder has a surface area such as a dendrite type and a layer thereof coated with the surface treatment agent is thin, contact characteristics between conductive fillers may be improved. Accordingly, the first silver powder may improve the thermal conductivity of the silicone-based resin composition.

The first silver powder may have an average particle diameter of about 0.5 $\mu$m to about 4 $\mu$m, about 1 $\mu$m to about 3 $\mu$m, or about 1.5 $\mu$m to about 2.5 $\mu$m.

The silicone-based resin composition may include the first silver powder in a content of about 300 parts by weight to about 1,000 parts by weight, about 400 parts by weight to about 900 parts by weight, or about 500 parts by weight to about 800 parts by weight based on 100 parts by weight of the organic polysiloxane.

The second conductive powder may include a second silver powder. The second silver powder may include spherical silver particles. The second silver powder may include surface-treated spherical silver particles. The second silver powder may include spherical silver particles coated with copper.

The second conductive powder may have a tap density of greater than about 3.0 $g/cm^3$, greater than about 3.01 $g/cm^3$, greater than about 4 $g/cm^3$, greater than about 5 $g/cm^3$, or greater than about 5 $g/cm^3$ and less than about 9 $g/cm^3$.

The second conductive powder may have a specific surface area of less than about 1 $m^2/g$ , less than about 0.9 $m^2/g$, less than about 0.8 $m^2/g$, less than about 0.7 $m^2/g$, or less than about 0.6 $m^2/g$.

An aspect ratio of the spherical silver particles included in the second silver powder may be about 1 to 2, about 1.2 to 1.7, or about 1.25 to 1.65.

The second silver powder may be surface-treated with a surface treatment agent. The surface treatment agent may include a C10 to C20 fatty acid.

The second silver powder may have an ignition loss (Ig-loss) of less than about 0.8 wt%, less than about 0.7 wt%, or less than about 0.6 wt%.

The second silver powder may have an average particle diameter of about 1.5 $\mu$m to about 5 $\mu$m, about 2 $\mu$m to about 4 $\mu$m, or about 2.5 $\mu$m to about 3.5 $\mu$m.

The silicone-based resin composition may include the second silver powder in a content of about 100 parts by weight to about 800 parts by weight, about 150 parts by weight to about 700 parts by weight, or about 170 parts by weight to about 600 parts by weight based on 100 parts by weight of the organic polysiloxane.

The conductive filler may include the first conductive powder and the second conductive powder in a weight ratio of 5:95 to 50:50. In general, even in the same silicone-based resin composition, the distribution characteristics of the conductive filler included in the silicone-based resin composition are different. Accordingly, a significant difference in thermal conductivity characteristics of final products may occur depending on a pressing pressure during a product manufacturing process. The conductive filler includes a first conductive powder and a second conductive powder including particles having a different shape from particles included in the first conductive powder, thereby improving the formation of an electrical network between the particles and improving thermal conductivity. In addition, the reliability of product performance may be improved because a variation in thermal conductivity change rates according to a difference in pressurization pressure during a commercialization process of the silicone-based resin composition is small. Further, the silicone-based resin composition may exhibit high thermal conductivity even when the filler is included in a low content.

The silicone-based resin composition may include the organic polysiloxane and the conductive filler in a weight ratio of 20:80 to 5:95, 20:80 to 6:94, or 20:80 to 10:90. When the range is satisfied, proper adhesion to an adherend may be maintained, and durability may be improved because voids and cracks due to thermal shock do not occur.

The silicone-based resin composition according to the present invention has a thermal conductivity change rate of 30% or less as measured by the following measurement method:

[Measurement method]

1) The silicone-based resin composition was molded by hot press for 15 minutes under conditions of 165°C and a pressure of 26 $kgf/cm^2$ to manufacture a first sheet, and separately, the silicone-based resin composition was molded by hot press for 15 minutes under conditions of 165°C and a pressure of 0.1 $kgf/cm^2$ to manufacture a second sheet.
2) The first sheet and the second sheet were cured at 150°C for 2 hours to respectively manufacture a sample of the first sheet and a sample of the second sheet.
3) A thermal conductivity of the first sheet sample and a thermal conductivity of the second sheet sample were measured at 25°C according to ISO 22007-2.
4) The thermal conductivity change rate was calculated according to Equation 2 below:

[Equation 2]

$$\text{Thermal conductivity change rate (\%)} = (\left| TC_{26} - TC_{0.1} \right| / TC_{26}) \times 100$$

(where $TC_{26}$ is a thermal conductivity (W/mK) of the first sheet sample, and $TC_{0.1}$ is a thermal conductivity (W/mK) of the second sheet sample.)

FIG. 1 sequentially illustrates a method of measuring the thermal conductivity of a silicone-based resin composition according to the present invention.

Referring to FIG. 1, each silicone-based resin composition 10 was fed into a mold 20, and then (a-1) the silicone-based resin composition 10 was molded by hot press for 15 minutes under conditions of 165°C and a pressure of 26 $kgf/cm^2$ to manufacture a first sheet 11, and separately, (a-2) the silicone-based resin composition 10 was molded by hot press for 15 minutes under conditions of 165°C and a pressure of 0.1 $kgf/cm^2$ to manufacture a second sheet 12.

Next, (b) the first sheet 11 and the second sheet 12 were cured for 2 hours cured at 150°C to manufacture a sample 11-1 of the first sheet and a sample 11-2 of the second sheet, respectively. The first sheet 11 and the second sheet 12 were fed into a dry oven 30 to be cured.

Next, (c) a thermal conductivity of the first sheet sample 11-1 and a thermal conductivity of the second sheet sample 11-2 were measured using a sensor 40 according to ISO 22007-2 at 25°C.

Next, a thermal conductivity change rate was calculated by substituting the measured thermal conductivity value of the first sheet sample 11-1 and the measured thermal conductivity value of the second sheet sample 11-2 into Equation 1.

A thermal conductivity change rate of the silicone-based resin composition measured by the measurement method may be 25% or less, 20% or less, 15% or less, or 10% or less.

Since the silicone-based resin composition has the thermal conductivity change rate, the reliability of product performance may be secured due to a small variation in the thermal conductivity change rate even when the silicone-based resin composition is commercialized under different pressurization conditions. In addition, even when thermal shock is applied to a product manufactured from the silicone-based resin composition, proper adhesion to an adherend may be maintained, and voids and cracks due to thermal shock do not occur.

The silicone-based resin composition may have a thermal conductivity per filler weight of 1 W/mK or more, 1.05 W/mK or more, 1.07 W/mK or more, 1.1 W/mK or more, or 1.2 W/mK or more calculated by Equation 3 below:

[Equation 3]

$$X/Y \times 10$$

(where X is a thermal conductivity, measured at 25°C, of the first sheet sample or the second sheet sample, and Y is weight% of the conductive filler based on the total weight of the silicone-based resin composition.)

Since the silicone-based resin composition has a thermal conductivity per filler weight of 1 W/mK or more calculated by Equation 3, a relatively high thermal conductivity may be expressed even when the silicone resin composition includes the same conductive filler.

the first sheet sample or the second sheet sample may have a thermal conductivity of 10 W/mK or more, 10.1 W/mK or more, 10.2 W/mK or more, 10.3 W/mK or more, or 10.5 W/mK or more measured at 25°C.

Since the first sheet sample or second sheet sample made of the silicone-based resin composition has a thermal conductivity within the above range, an appropriate heat dissipation function may be performed even when the silicone-based resin composition is commercialized under different pressure conditions.

The silicone-based resin composition may further include a tackifier.

The tackifier may include alkoxysilane. In addition, the tackifier may include an epoxy group. The tackifier may be at least one selected from the group consisting of 2-(3,4 epoxycyclohexyl) ethyltrimethoxysilane, 3-glycidoxypropyl methyldimethoxysilane, 3-glycidoxypropyl trimethoxysilane, 3-glycidoxypropyl methyldiethoxysilane, and 3-glycidoxypropyl triethoxysilane.

The silicone-based resin composition may include the tackifier in a content of about 1 part by weight to about 20 parts by weight, about 1 part by weight to about 10 parts by weight, or about 2 parts by weight to about 8 parts by weight based on 100 parts by weight of the organic polysiloxane. The tackifier may improve adhesive strength between the organic polysiloxane and the conductive filler.

The silicone-based resin composition may further include a curing catalyst. The curing catalyst may accelerate curing of the silicone-based resin composition.

The curing catalyst may include a platinum-based catalyst.

Examples of the curing catalyst include organic titanate esters such as platinum-divinyltetramethyldisiloxane complex, tetrabutyl titanate, and tetraisopropyl titanate; organic titanium chelate compounds such as diisopropoxybis(acetylacetate)titanium and diisopropoxybis(ethylacetoacetate)titanium; organoaluminum compounds such as aluminum tris(acetylacetonate) and aluminum tris(ethylacetoacetate); organic zirconium compounds such as zirconium tetra(acetylacetonate) and zirconium tetrabutylate; organic tin compounds such as dibutyltin dioctoate, dibutyltin dilaurate, and butyltin-2-ethylhexoate; metal salts of organic carboxylic acids such as tin naphthenate, tin oleate, tin butyrate, cobalt naphthenate, and zinc stearate; amine compounds such as hexylamine and dodecylamine phosphate and salts thereof; quaternary ammonium salts such as benzyltriethylammonium acetate; lower fatty acid salts of alkali metals such as potassium acetate; dialkyl hydroxylamines such as dimethylhydroxylamine and diethylhydroxylamine; and guanidyl group-containing organosilicon compounds.

The silicone-based resin composition may include the curing catalyst in a content of about 0.01 parts by weight to about 5 parts by weight, about 0.03 parts by weight to about 3 parts by weight, or about 0.1 parts by weight to about 2 parts by weight based on 100 parts by weight of the organic polysiloxane.

The silicone-based resin composition may further include a reaction inhibitor. The reaction inhibitor may be at least one selected from the group consisting of acetylenic compounds such as 2-methyl-3-butyn-2-ol, 2-phenyl-3-butyn-2-ol, and 1-ethynyl-1-cyclohexanol; ene-yne compounds such as 3-methyl-3-penten-1-yne and 3,5-dimethyl-3-hexen-1-yne; curing reaction inhibitors such as hydrazine-based compounds, phosphine-based compounds, and mercaptan-based compound; and the like.

The silicone-based resin composition may include the reaction inhibitor in a content of about 0.0001 parts by weight to about 10 parts by weight based on 100 parts by weight of the organic polysiloxane.

<Method of preparing silicone-based resin composition>

A method of preparing the silicone-based resin composition may be a known preparation method, without being specifically limited.

For example, the silicone-based resin composition may be prepared by mixing the organic polysiloxane, the conductive filler, the tackifier, the curing catalyst, the curing reaction inhibitor, and the like for 30 minutes to 4 hours using a mixer such as Trimix, Twinmix, and a planetary mixer (all of which are manufactured by Inoue Seisakusho Co., Ltd., registered trademark); Ultramixer (manufactured by Mizuho Kogyo Co., Ltd., registered trademark); or Hibis Disper Mix (manufactured by Primix Co., Ltd., registered trademark). **In** the mixing process, a process temperature may be about 0°C to about 25°C.

<Semiconductor device>

FIG. 2 schematically illustrates a semiconductor device according to the present invention.

Referring to FIG. 2, the semiconductor device may include a circuit board 100, a semiconductor package 200, conductive bumps 300, a heat dissipation part 400 and a heat conduction layer 500.

The semiconductor device according to the present invention includes the semiconductor package 200, the heat dissipation part 400 disposed on the semiconductor package 200, and the heat conduction layer 500 interposed between the semiconductor package 200 and the heat dissipation part 400, wherein the heat conduction layer 500 includes a silicone-based resin composition, and the silicone-based resin composition includes an organic polysiloxane and a

conductive filler and has a thermal conductivity change rate of 30% or less as measured by the following measurement method:

[Measurement method]

1) The silicone-based resin composition was molded by hot press for 15 minutes under conditions of 165°C and a pressure of 26 kgf/cm$^2$ to manufacture a first sheet, and separately, the silicone-based resin composition was molded by hot press for 15 minutes under conditions of 165°C and a pressure of 0.1 kgf/cm$^2$ to manufacture a second sheet.
2) The first sheet and the second sheet were cured at 150°C for 2 hours to respectively manufacture a sample of the first sheet and a sample of the second sheet.
3) A thermal conductivity of the first sheet sample and a thermal conductivity of the second sheet sample were measured at 25°C according to ISO 22007-2.
4) A thermal conductivity change rate is calculated according to Equation 2 below:

[Equation 2]

$$\text{Thermal conductivity change rate (\%)} = (\left| TC_{26} - TC_{0.1} \right| / TC_{26}) \times 100$$

(where $TC_{26}$ is a thermal conductivity (W/mK) of the first sheet sample, and $TC_{0.1}$ is a thermal conductivity (W/mK) of the second sheet sample.)

A specific method of measuring the thermal conductivity change rate of the silicone-based resin composition is the same as shown in FIG. 1.

Since the silicone-based resin composition has a thermal conductivity change rate, the heat conduction layer 500 including the silicone-based resin composition has a small variation in a thermal conductivity change rate, so that reliability of product performance may be secured. In addition, even if thermal shock is applied to the thermal conductive layer 500, proper adhesion to the semiconductor package 200 and the heat dissipation part 400 may be maintained, and voids and cracks due to thermal shock do not occur.

The circuit board 100 may support the semiconductor package 200, the conductive bumps 300, the heat dissipation part 400 and the heat conduction layer 500.

The circuit board 100 may include a circuit pattern. The circuit board 100 may include a plurality of circuit patterns disposed inside a flat body including an insulating and heat-resistant material and having a predetermined strength. In addition, the circuit board 100 may include a connection pad electrically connected to the circuit pattern and disposed on the body.

For example, the body of the circuit board 100 may include a thermosetting resin-based substrate such as an epoxy resin substrate or a polyimide substrate, a flat plate, or a flat plate attached with a heat-resistant organic film such as a liquid crystal polyester film or a polyamide film. The circuit pattern may be disposed inside the body in a pattern shape and may include power wiring for power supply, ground wiring, and signal wiring for signal transmission. Each wiring may be disposed to be separated from each other by a plurality of interlayer insulating films formed on upper and lower surfaces of the body.

The connection pad may be exposed to the outside from the upper surface of the body and may be connected to the circuit pattern. Therefore, an external connection body connected to the circuit board 100 may be electrically connected to an internal circuit pattern through the connection pad.

Various electronic components may be mounted on a connection pad included in the circuit board 100. That is, the circuit board 100 may be a system board on which electronic components including the semiconductor package 200 are mounted.

The semiconductor package 200 may be mounted on the circuit board 100. The semiconductor package 200 may be disposed on the circuit board 100. The semiconductor package 200 may be connected to the circuit board 100 through the conductive bumps 300.

The semiconductor package 200 may include a semiconductor chip including an integrated circuit, a semiconductor package substrate connected to the semiconductor chip, a conductive solder for connecting the semiconductor chip and the semiconductor package substrate, and a sealing part for sealing the semiconductor chip and the conductive solder. The sealing part may include a resin composition such as epoxy molding.

The semiconductor package 200 may be a memory device, a central processing unit, or the like.

The conductive bumps 300 may be disposed between the semiconductor package 200 and the circuit board 100.

The conductive bumps 300 may electrically connect the semiconductor package 200 and the circuit board 100 to each other. The conductive bumps 300 may be electrically connected to the semiconductor package 200 and the connection pad.

The heat dissipation part 400 may be disposed on the semiconductor package 200. The heat dissipation part 400 may cover the semiconductor package 200. The heat dissipation part 400 may be bonded to the circuit board 100. The heat dissipation part 400 may cover a side surface of the semiconductor package 200.

The heat dissipation part 400 may include a conductor. The heat dissipation part 400 may include metal. The heat dissipation part 400 may be thermally connected to an external heat dissipation fin.

**In** addition, the heat dissipation part 400 may protect the semiconductor package 200 against external physical impact. The heat dissipation part 400 may protect the semiconductor package 200 against external electromagnetic waves. That is, the heat dissipation part 400 may block external electromagnetic waves.

The heat conduction layer 500 may be disposed between the semiconductor package 200 and the heat dissipation part 400. The heat conduction layer 500 may directly contact the semiconductor package 200 and the heat dissipation part 400. The heat conduction layer 500 may be in close contact between the semiconductor package 200 and the heat dissipation part 400.

The heat conduction layer 500 may be thermally connected to the semiconductor package 200 and the heat dissipation part 400. That is, the heat conduction layer 500 may transfer heat generated from the semiconductor package 200 to the heat dissipation part 400.

The thickness of the heat conduction layer 500 may be about 1 $\mu$m to about 100 $\mu$m, about 2 $\mu$m to about 70 $\mu$m, about 5 $\mu$m to about 60 $\mu$m, or about 10 $\mu$m to about 40 $\mu$m.

<Method of manufacturing semiconductor device >

A method of manufacturing the semiconductor device may be a known manufacturing method, without being specifically limited.

First, the semiconductor package 200 may be mounted on the circuit board 100 by the conductive bumps 300. Next, the silicone-based resin composition may be coated on the semiconductor package 200. Alternatively, the silicone-based resin composition may be coated on a lower surface of the heat dissipation part 400.

Next, the heat dissipation part 400 may cover the semiconductor package 200. Accordingly, the coated silicone-based resin composition may be in direct contact with the lower surface of the heat dissipation part 400 and the upper surface of the semiconductor package 200, and the curable silicone resin composition may be cured at about 80°C or more in a state in which a pressure of about 0.01 MPa or more is applied.

A pressure in the curing process may be about 0.01 MPa or more. The pressure in the curing process may be about 0.05 MPa to about 100 MPa. The pressure in the curing process may be about 0.1 MPa to about 100 MPa.

A temperature in the curing process may be about 110°C to about 300°C. The temperature in the curing process may be about 120°C to about 300°C. The temperature in the curing process may be about 140°C to about 300°C. A curing time in the curing process may be about 30 minutes to about 5 hours. The heat conduction layer 500 may be formed by the process.

Hereinafter, the present invention is described in more detail based on Examples and Comparative Examples. However, the following Examples and Comparative Examples are only examples for explaining the present invention in more detail, and the present invention is not limited by the following Examples and Comparative Examples.

## Example

- Organic polysiloxane #1: Compound represented by the above Formula 4 having a viscosity of 20,000 cPs at 23°C and including a silicon-bonded alkenyl group
- Organic polysiloxane #2: Compound represented by the above Formula 6 having a viscosity of 1,000 cPs at 23°C and including a structure in which hydrogen groups are bonded to both ends thereof
- Organic polysiloxane #3: Compound represented by the above Formula 8 having a viscosity of 1,000 cPs at 23°C and including a structure in which a hydrogen group is bonded to a side chain thereof
- Conductive filler #1: Silver powder having a tap density of about 0.7 g/cm$^3$, a specific surface area of about 1.3m$^2$/g, an average particle size uniformity ($(D_{90} - D_{50})/(D_{50} - D_{10})$) of 1.1, an aspect ratio of 12 (dendrite type), and an Ig-loss of 0.4 % by weight at about 538°C, and surface-treated with fatty acids
- Conductive filler #2: Silver powder having a tap density of about 6.4 g/cm$^3$, a specific surface area of about 0.3 m$^2$/g, an average particle size uniformity ($(D_{90} - D_{50})/(D_{50} - D_{10})$) of 1.8, an aspect ratio of 1.5 (spherical), and an Ig-loss of 0.05 % by weight at about 538°C

- Tackifier: 3-glycididoxy propyltrimethoxy silane
- Curing catalyst: Platinum-divinyltetramethyldisiloxane complex
- Reaction inhibitor: 1-ethynyl-1-cyclohexanol

**Examples 1 to 4 and Comparative Examples 1 to** 4

A silicone-based resin composition was prepared by adding each composition shown in Table 1 below to a planetary mixer and uniformly mixing at room temperature at a speed of about 40 rpm for 1 hour.

[Table 1]

| Classification | Organic polysiloxane #1 | Organic polysiloxane #2 | Organic polysiloxane #3 | Conductive filler #1 | Conductive filler #2 | Tackifier | Curing catalyst | Reaction inhibitor |
|---|---|---|---|---|---|---|---|---|
| Unit | % by weight | | | | | | | |
| Example 1 | 7.5 | 1.3 | 0.5 | 25 | 65 | 0.5 | 0.1 | 0.1 |
| Example 2 | 7.5 | 1.3 | 0.5 | 35 | 55 | 0.5 | 0.1 | 0.1 |
| Example 3 | 7.5 | 1.3 | 0.5 | 42 | 48 | 0.5 | 0.1 | 0.1 |
| Example 4 | 7.5 | 1.3 | 0.5 | 7 | 83 | 0.5 | 0.1 | 0.1 |
| Comparative Example 1 | 7.5 | 1.3 | 0.5 | 2 | 88 | 0.5 | 0.1 | 0.1 |
| Comparative Example 2 | 7.5 | 1.3 | 0.5 | 88 | 2 | 0.5 | 0.1 | 0.1 |
| Comparative Example 3 | 7.5 | 1.3 | 0.5 | 90 | Not included | 0.5 | 0.1 | 0.1 |
| Comparative Example 4 | 7.5 | 1.3 | 0.5 | Not included | 90 | 0.5 | 0.1 | 0.1 |

**Experimental example**

<Manufacture of samples>

A sheet was manufactured by molding the silicone-based resin composition of each of Examples 1 to 4 and Comparative Examples 1 to 4 by hot press under temperature, pressure, and time conditions shown in Table 2 below. Next, the sheet was cured at 150°C for 2 hours, and then manufactured into a sample having a width of 30 mm, a length of 30 mm, and a thickness of 4 mm.

[Table 2]

| Classification | | Temperature | Pressure | Time |
|---|---|---|---|---|
| Unit | | °C | kgf/ $cm^2$ | min |
| Example 1 | Example 1-1 | 165 | 26 | 15 |
| | Example 1-2 | 165 | 13 | 15 |
| | Example 1-3 | 165 | 5 | 15 |
| | Example 1-4 | 165 | 1 | 15 |
| | Example 1-5 | 165 | 0.1 | 15 |

(continued)

| Classification | | Temperature | Pressure | Time |
|---|---|---|---|---|
| Unit | | °C | kgf/ $cm^2$ | min |
| Example 2 | Example 2-1 | 165 | 26 | 15 |
| | Example 2-2 | 165 | 13 | 15 |
| | Example 2-3 | 165 | 5 | 15 |
| | Example 2-4 | 165 | 1 | 15 |
| | Example 2-5 | 165 | 0.1 | 15 |
| Example 3 | Example 3-1 | 165 | 26 | 15 |
| | Example 3-2 | 165 | 13 | 15 |
| | Example 3-3 | 165 | 5 | 15 |
| | Example 3-4 | 165 | 1 | 15 |
| | Example 3-5 | 165 | 0.1 | 15 |
| Example 4 | Example 4-1 | 165 | 26 | 15 |
| | Example 4-2 | 165 | 13 | 15 |
| | Example 4-3 | 165 | 5 | 15 |
| | Example 4-4 | 165 | 1 | 15 |
| | Example 4-5 | 165 | 0.1 | 15 |
| Comparative Example 1 | Comparative Example 1-1 | 165 | 26 | 15 |
| | Comparative Example 1-2 | 165 | 13 | 15 |
| | Comparative Example 1-3 | 165 | 5 | 15 |
| | Comparative Example 1-4 | 165 | 1 | 15 |
| | Comparative Example 1-5 | 165 | 0.1 | 15 |
| Comparative Example 2 | Comparative Example 2-1 | 165 | 26 | 15 |
| | Comparative Example 2-2 | 165 | 13 | 15 |
| | Comparative Example 2-3 | 165 | 5 | 15 |
| | Comparative Example 2-4 | 165 | 1 | 15 |
| | Comparative Example 2-5 | 165 | 0.1 | 15 |
| Comparative Example 3 | Comparative Example 3-1 | 165 | 26 | 15 |
| | Comparative Example 3-2 | 165 | 13 | 15 |
| | Comparative Example 3-3 | 165 | 5 | 15 |
| | Comparative Example 3-4 | 165 | 1 | 15 |
| | Comparative Example 3-5 | 165 | 0.1 | 15 |
| Comparative Example 4 | Comparative Example 4-1 | 165 | 26 | 15 |
| | Comparative Example 4-2 | 165 | 13 | 15 |
| | Comparative Example 4-3 | 165 | 5 | 15 |
| | Comparative Example 4-4 | 165 | 1 | 15 |
| | Comparative Example 4-5 | 165 | 0.1 | 15 |

**Experimental Example 1 - Thermal conductivity measurement**

The thermal conductivity of the samples manufactured in Example 1-1 to Comparative Example 4-5 was

measured according to the ISO 22007-2 method at 25°C using a thermal conductivity analyzer (model name: TPS-2500S, manufacturer: Hot Disk AB). Results are shown in Table 3 below.

**Experimental Example 2 - Thermal conductivity measurement after thermal shock**

The samples manufactured in Example 1-1 to Comparative Example 4-5 were placed in a thermal shock tester (product name: TSE-11-A) set to alternately repeat -40°C and 125°C for 30 minutes each. After repeating this 300 times, a thermal conductivity was measured in the same manner as in Experimental Example 1. Results are shown in Table 3 below.

**Experimental Example 3 - Appearance evaluation**

After repeating 300 times according to Experimental Example 2, the states of the samples of Examples 1-1 to Comparative Examples 4-5 were visually observed. A state without voids and cracks was evaluated as O, and a state with voids or cracks was evaluated as X. Results are shown in Table 3 below.

[Table 3]

| Classification | | Thermal conductivity | Thermal conductivity change rate1) | Thermal conductivity after thermal shock | Appearance evaluation | Thermal conductivity per filler weight2) |
|---|---|---|---|---|---|---|
| Unit | | W/mK | % | W/mK | - | W/mK |
| Example 1 | Example 1-1 | 11.0 | 8.2 | 11.0 | O | 1.22 |
| | Example 1-2 | 10.9 | | 10.9 | O | 1.21 |
| | Example 1-3 | 10.7 | | 10.6 | O | 1.19 |
| | Example 1-4 | 10.5 | | 10.4 | O | 1.17 |
| | Example 1-5 | 10.1 | | 9.9 | O | 1.12 |
| Example 2 | Example 2-1 | 10.9 | 7.3 | 10.9 | O | 1.21 |
| | Example 2-2 | 10.8 | | 10.8 | O | 1.20 |
| | Example 2-3 | 10.7 | | 10.6 | O | 1.19 |
| | Example 2-4 | 10.5 | | 10.3 | O | 1.17 |
| | Example 2-5 | 10.1 | | 9.9 | O | 1.12 |
| Example 3 | Example 3-1 | 10.8 | 7.4 | 10.8 | O | 1.20 |
| | Example 3-2 | 10.6 | | 10.6 | O | 1.18 |
| | Example 3-3 | 10.5 | | 10.4 | O | 1.17 |
| | Example 3-4 | 10.3 | | 10.1 | O | 1.14 |
| | Example 3-5 | 10.0 | | 9.8 | O | 1.11 |
| Example 4 | Example 4-1 | 11.2 | 9.8 | 11.2 | O | 1.24 |
| | Example 4-2 | 11.0 | | 11.0 | O | 1.22 |
| | Example 4-3 | 10.8 | | 10.8 | O | 1.20 |
| | Example 4-4 | 10.6 | | 10.5 | O | 1.18 |
| | Example 4-5 | 10.1 | | 9.8 | O | 1.12 |
| Comparative Example 1 | Comparative Example 1-1 | 11.3 | 32.7 | 11.2 | O | 1.26 |
| | Comparative Example 1-2 | 10.1 | | 10.0 | O | 1.12 |

(continued)

| Classification | | Thermal conductivity | Thermal conductivity change rate[1)] | Thermal conductivity after thermal shock | Appearance evaluation | Thermal conductivity per filler weight[2)] |
|---|---|---|---|---|---|---|
| Unit | | W/mK | % | W/mK | - | W/mK |
| | Comparative Example 1-3 | 9.5 | | 9.0 | O | 1.06 |
| | Comparative Example 1-4 | 8.5 | | 7.9 | X | 0.94 |
| | Comparative Example 1-5 | 7.6 | | 7.1 | X | 0.84 |
| Comparative Example 2 | Comparative Example 2-1 | 9.1 | 36.3 | 8.9 | O | 1.01 |
| | Comparative Example 2-2 | 8.5 | | 8.4 | X | 0.94 |
| | Comparative Example 2-3 | 7.7 | | 7.3 | X | 0.86 |
| | Comparative Example 2-4 | 6.3 | | 5.8 | X | 0.70 |
| | Comparative Example 2-5 | 5.8 | | 5.2 | X | 0.64 |
| Comparative Example 3 | Comparative Example 3-1 | 8.0 | 77.5 | 7.5 | X | 0.89 |
| | Comparative Example 3-2 | 7.1 | | 6.5 | X | 0.79 |
| | Comparative Example 3-3 | 5.4 | | 4.9 | X | 0.60 |
| | Comparative Example 3-4 | 2.1 | | 1.5 | X | 0.23 |
| | Comparative Example 3-5 | 1.8 | | 1.1 | X | 0.20 |
| Comparative Example 4 | Comparative Example 4-1 | 11.2 | 79.5 | 11.1 | O | 1.24 |
| | Comparative Example 4-2 | 9.4 | | 9.3 | O | 1.04 |
| | Comparative Example 4-3 | 5.6 | | 5.3 | X | 0.62 |
| | Comparative Example 4-4 | 3.9 | | 3.3 | X | 0.43 |
| | Comparative Example 4-5 | 2.3 | | 1.7 | X | 0.26 |

1) Thermal conductivity change rate: (Maximum value of thermal conductivity - Minimum value of thermal conductivity / Maximum value of thermal conductivity) × 100

2) Thermal conductivity per filler weight: (Thermal conductivity value / % by weight of conductive filler based on total weight of silicone-based resin composition) × 10

Referring to Tables 1 to 3, it was confirmed that even in the case of the silicone-based resin compositions having the same composition, the thermal conductivity characteristics are expressed differently depending on the applied

pressure. Specifically, it was confirmed that Examples 1 to 4 do not have a large variation in thermal conductivity regardless of the pressure applied during the sheet manufacturing process and have thermal conductivity after thermal shock similar to thermal conductivity before thermal shock so that heat dissipation is excellent and voids and cracks do not occur after thermal shock, thereby having excellent durability. In addition, it was confirmed that Examples 1 to 4 exhibit relatively high thermal conductivity, based on the same conductive filler content, compared to Comparative Examples 1 to 4.

In Comparative Examples 1 to 4, the thermal conductivity change rate exceeded 30% depending upon the pressure applied during the sheet manufacturing process, and a large deviation between the thermal conductivity before thermal shock and the thermal conductivity after thermal shock was exhibited. In addition, in Comparative Examples 1 to 4, voids and cracks occurred after thermal shock. Accordingly, it was confirmed that heat dissipation and durability of Comparative Examples 1 to 4 were decreased compared to Examples. Further, it was confirmed that Comparative Examples 1 to 4 exhibit relatively low thermal conductivity, based on the same conductive filler content, compared to Examples 1 to 4.

[Description of Symbols]

10: silicone-based resin composition
11: first sheet
12: second sheet
11-1: sample of first sheet
12-1: sample of second sheet
20: mold
30: dry oven
40: sensor
100: circuit board
200: semiconductor package
300: conductive bump
400: heat dissipation part
500: heat conduction layer

## Claims

**1.** A silicone-based resin composition, comprising:

an organic polysiloxane; and
a conductive filler,
wherein the conductive filler comprises a first conductive powder comprising dendrite-type particles and a second conductive powder comprising spherical particles,
wherein the first conductive powder and the second conductive powder in a weight ratio of 5:95 to 50:50,
wherein the first conductive powder comprises silver powder surface-treated with a C10 to C20 fatty acid, and
wherein the silicone-based resin composition has a thermal conductivity change rate of 30% or less as measured by Measurement method below:
[Measurement method]

1) the silicone-based resin composition is molded by hot press for 15 minutes under conditions of 165°C and a pressure of 26 $kgf/cm^2$ to manufacture a first sheet, and separately, the silicone-based resin composition is molded by hot press for 15 minutes under conditions of 165°C and a pressure of 0.1 $kgf/cm^2$ to manufacture a second sheet.
2) the first sheet and the second sheet are cured at 150°C for 2 hours to respectively manufacture a sample of the first sheet and a sample of the second sheet.
3) a thermal conductivity of the first sheet sample and a thermal conductivity of the second sheet sample are measured at 25°C according to ISO 22007-2.
4) a thermal conductivity change rate is calculated according to Equation 2 below:

[Equation 2]

$$\text{Thermal conductivity change rate (\%)} = (\left| TC_{26} - TC_{0.1} \right| / TC_{26}) \times 100$$

where $TC_{26}$ is a thermal conductivity (W/mK) of the first sheet sample, and $TC_{0.1}$ is a thermal conductivity (W/mK) of the second sheet sample.

**2.** The silicone-based resin composition according to claim 1, wherein the silicone-based resin composition comprises the organic polysiloxane and the conductive filler in a weight ratio of 20:80 to 5:95.

**3.** The silicone-based resin composition according to claim 1, wherein the first conductive powder has a tap density of 0.1 g/cm$^3$ to 3.0 g/cm$^3$.

**4.** The silicone-based resin composition according to claim 1, wherein the first conductive powder has a specific surface area of 0.2 m$^2$/g to 5.0 m$^2$/g,

the specific surface area, about 2 g of silver powder is taken as a sample, and after degassing at 60±5°C for 10 minutes, a total surface area is measured with an automatic specific surface area measuring device (BET method),
the amount of the sample is weighed, and the specific surface area is calculated according to the following equation:

$$\text{Specific surface area } (m^2/g) = \text{total surface area } (m^2)/\text{sample amount (g)}.$$

**5.** The silicone-based resin composition according to claim 1, wherein the silicone-based resin composition has a thermal conductivity per filler weight of 1 W/mK or more calculated by Equation 3 below:

[Equation 3]

$$X/Y \times 10$$

where X is a thermal conductivity, measured at 25°C, of the first sheet sample or the second sheet sample, and, Y is weight% of the conductive filler based on a total weight of the silicone-based resin composition.

**6.** The silicone-based resin composition according to claim 2, wherein the first sheet sample or the second sheet sample has a thermal conductivity of 10 W/mK or more measured at 25°C.

**7.** A semiconductor device, comprising:

a semiconductor package;
a heat dissipation part disposed on the semiconductor package; and
a heat conduction layer interposed between the semiconductor package and the heat dissipation part,
wherein the heat conduction layer comprises a silicone-based resin composition,
wherein the silicone-based resin composition comprises an organic polysiloxane and a conductive filler,
wherein the conductive filler comprises a first conductive powder comprising dendrite-type particles and a second conductive powder comprising spherical particles,
wherein the first conductive powder and the second conductive powder in a weight ratio of 5:95 to 50:50,
wherein the first conductive powder comprises silver powder surface-treated with a C10 to C20 fatty acid, and
the silicone-based resin composition has a thermal conductivity change rate of 30% or less measured by Measurement method below:
[Measurement method]

1) the silicone-based resin composition is molded by hot press for 15 minutes under conditions of 165°C and a pressure of 26 kgf/cm$^2$ to manufacture a first sheet, and separately, the silicone-based resin composition is molded by hot press for 15 minutes under conditions of 165°C and a pressure of 0.1 kgf/cm$^2$ to manufacture a

second sheet.

2) the first sheet and the second sheet are cured at 150°C for 2 hours to respectively manufacture a sample of the first sheet and a sample of the second sheet.

3) a thermal conductivity of the first sheet sample and a thermal conductivity of the second sheet sample are measured at 25°C according to ISO 22007-2.

4) a thermal conductivity change rate is calculated according to Equation 2 below:

[Equation 2]

$$\text{Thermal conductivity change rate (\%)} = (\left| TC_{26} - TC_{0.1} \right| / TC_{26}) \times 100$$

where $TC_{26}$ is a thermal conductivity (W/mK) of the first sheet sample, and $TC_{0.1}$ is a thermal conductivity (W/mK) of the second sheet sample.

## Patentansprüche

**1.** Harzzusammensetzung auf Silikonbasis, umfassend:

ein organisches Polysiloxan; und
einen leitfähigen Füllstoff,
wobei der leitfähige Füllstoff ein erstes leitfähiges Pulver umfassend Dendritpartikel und ein zweites leitfähiges Pulver umfassend sphärische Partikel umfasst,
wobei das erste leitfähige Pulver und das zweite leitfähige Pulver in einem Gewichtsverhältnis von 5:95 bis 50:50,
wobei das erste leitfähige Pulver Silberpulver umfasst, das mit einer C10- bis C20-Fettsäure oberflächenbehandelt ist, und
wobei die Harzzusammensetzung auf Silikonbasis eine Wärmeleitfähigkeitsveränderungsrate von 30 % oder weniger, wie durch das nachstehende Messverfahren gemessen, aufweist:
[Messverfahren]

1) die Harzzusammensetzung auf Silikonbasis wird durch Heißpressen für 15 Minuten unter Bedingungen von 165 °C und einem Druck von 26 $kgf/cm^2$ geformt, um eine erste Folie herzustellen, und getrennt wird die Harzzusammensetzung auf Silikonbasis durch Heißpressen für 15 Minuten unter Bedingungen von 165 °C und einem Druck von 0,1 $kgf/cm^2$ geformt, um eine zweite Folie herzustellen,

2) die erste Folie und die zweite Folie werden bei 150 °C für 2 Stunden gehärtet, um jeweils eine Probe der ersten Folie und eine Probe der zweiten Folie herzustellen,

3) eine Wärmeleitfähigkeit der ersten Folienprobe und eine Wärmeleitfähigkeit der zweiten Folienprobe werden bei 25 °C nach ISO 22007-2 gemessen,

4) eine Wärmeleitfähigkeitsveränderungsrate wird nach der nachstehenden Gleichung 2 berechnet:

$$\text{Wärmeleitfähigkeitsveränderungsrate (\%)} = (|TC_{26} - TC_{0,1}|/TC_{26}) \times 100 \quad \text{[Gleichung 2]}$$

wobei $TC_{26}$ eine Wärmeleitfähigkeit (W/mK) der ersten Folienprobe ist und $TC_{0,1}$ eine Wärmeleitfähigkeit (W/mK) der zweiten Folienprobe ist.

**2.** Harzzusammensetzung auf Silikonbasis nach Anspruch 1, wobei die Harzzusammensetzung auf Silikonbasis das organische Polysiloxan und den leitfähigen Füllstoff in einem Gewichtsverhältnis von 20:80 bis 5:95 umfasst.

**3.** Harzzusammensetzung auf Silikonbasis nach Anspruch 1, wobei das erste leitfähige Pulver eine Klopfdichte von 0,1 $g/cm^3$ bis 3,0 $g/cm^3$ aufweist.

**4.** Harzzusammensetzung auf Silikonbasis nach Anspruch 1, wobei das erste leitfähige Pulver eine spezifische Oberfläche von 0,2 $m^2/g$ bis 5,0 $m^2/g$ aufweist,

wobei für die spezifische Oberfläche etwa 2 g Silberpulver als Probe genommen werden und nach 10 Minuten Entgasen bei 60±5 °C eine Gesamtoberfläche mit einer automatischen Spezifische-Oberfläche-Messvorrichtung (BET-Verfahren) gemessen wird,

die Menge der Probe gewogen wird und die spezifische Oberfläche gemäß der nachstehenden Gleichung berechnet wird:

Spezifische Oberfläche ($m^2/g$) = Gesamtoberfläche ($m^2$)/Probenmenge (g) .

5. Harzzusammensetzung auf Silikonbasis nach Anspruch 1, wobei die Harzzusammensetzung auf Silikonbasis eine Wärmeleitfähigkeit pro Füllstoffgewicht von 1 W/mK oder mehr, berechnet durch die nachstehende Gleichung 3, aufweist:

[Gleichung 3]

$$X/Y \times 10$$

wobei X eine Wärmeleitfähigkeit, gemessen bei 25 °C, der ersten Folienprobe oder der zweiten Folienprobe ist und Y Gew.-% des leitfähigen Füllstoffs, bezogen auf ein Gesamtgewicht der Harzzusammensetzung auf Silikonbasis, ist.

6. Harzzusammensetzung auf Silikonbasis nach Anspruch 2, wobei die erste Folienprobe oder die zweite Folienprobe eine Wärmeleitfähigkeit von 10 W/mK oder mehr, gemessen bei 25 °C, aufweist.

7. Halbleitervorrichtung umfassend:

ein Halbleiterpaket;
einen Wärmeableitungsteil, der auf dem Halbleiterpaket angeordnet ist; und
eine Wärmeleitungsschicht, die zwischen dem Halbleiterpaket und dem Wärmeableitungsteil angeordnet ist,
wobei die Wärmeleitungsschicht eine Harzzusammensetzung auf Silikonbasis umfasst,
wobei die Harzzusammensetzung auf Silikonbasis ein organisches Polysiloxan und einen leitfähigen Füllstoff umfasst,
wobei der leitfähige Füllstoff ein erstes leitfähiges Pulver umfassend Dendritpartikel und ein zweites leitfähiges Pulver umfassend sphärische Partikel umfasst,
wobei das erste leitfähige Pulver und das zweite leitfähige Pulver in einem Gewichtsverhältnis von 5:95 bis 50:50,
wobei das erste leitfähige Pulver Silberpulver umfasst, das mit einer C10- bis C20-Fettsäure oberflächenbehandelt ist, und
die Harzzusammensetzung auf Silikonbasis eine Wärmeleitfähigkeitsänderungsrate von 30 % oder weniger, gemessen durch das nachstehende Messverfahren, aufweist:
[Messverfahren]

1) die Harzzusammensetzung auf Silikonbasis wird durch Heißpressen für 15 Minuten unter Bedingungen von 165 °C und einem Druck von 26 kgf/$cm^2$ geformt, um eine erste Folie herzustellen, und getrennt wird die Harzzusammensetzung auf Silikonbasis durch Heißpressen für 15 Minuten unter Bedingungen von 165 °C und einem Druck von 0,1 kgf/$cm^2$ geformt, um eine zweite Folie herzustellen,
2) die erste Folie und die zweite Folie werden bei 150 °C für 2 Stunden gehärtet, um jeweils eine Probe der ersten Folie und eine Probe der zweiten Folie herzustellen,
3) eine Wärmeleitfähigkeit der ersten Folienprobe und eine Wärmeleitfähigkeit der zweiten Folienprobe werden bei 25 °C nach ISO 22007-2 gemessen,
4) eine Wärmeleitfähigkeitsveränderungsrate wird nach der nachstehenden Gleichung 2 berechnet:

$$\text{Wärmeleitfähigkeitsveränderungsrate (\%)} = (|TC_{26} - TC_{0,1}|/TC_{26}) \times 100 \qquad \text{[Gleichung 2]}$$

wobei $TC_{26}$ eine Wärmeleitfähigkeit (W/mK) der ersten Folienprobe ist und $TC_{0,1}$ eine Wärmeleitfähigkeit (W/mK) der zweiten Folienprobe ist.

## Revendications

1. Composition de résine à base de silicone comprenant

un polysiloxane organique ; et
une charge conductrice,
dans laquelle la charge conductrice comprend une première poudre conductrice comportant des particules de type dendrite et une deuxième poudre conductrice comprenant des particules sphériques,
dans laquelle la première poudre conductrice et la deuxième poudre conductrice sont présentes en un rapport pondéral de 5:95 à 50:50,
dans laquelle la première poudre conductrice comprend de la poudre d'argent traitée en surface avec un acide gras en C10 à C20, et
dans laquelle la composition de résine à base de silicone possède un taux de variation de conductivité thermique de 30 % ou moins tel que mesuré par le procédé de mesure ci-dessous :
[Procédé de mesure]

1) on moule la composition de résine à base de silicone par presse à chaud pendant 15 minutes dans des conditions de 165 °C et une pression de 26 kgf/cm$^2$ pour fabriquer une première feuille, et séparément, on moule la composition de résine à base de silicone par presse à chaud pendant 15 minutes dans des conditions de 165 °C et une pression de 0,1 kgf/cm$^2$ pour fabriquer une deuxième feuille,
2) on durcit la première feuille et la deuxième feuille à 150 °C pendant 2 heures pour fabriquer respectivement un échantillon de la première feuille et un échantillon de la deuxième feuille,
3) une conductivité thermique du premier échantillon de feuille et une conductivité thermique du second échantillon de feuille sont mesurées à 25 °C selon la norme ISO 22007-2,
4) un taux de variation de conductivité thermique est calculé selon l'équation 2 ci-dessous :

$$\text{taux de variation de conductivité thermique (\%)} = (|TC_{26} - TC_{0,1}|/TC_{26}) \times 100 \qquad \text{[Équation 2]}$$

où $TC_{26}$ est une conductivité thermique (W/mK) du premier échantillon de feuille, et $TC_{0,1}$ est une conductivité thermique (W/mK) du second échantillon de feuille.

**2.** Composition de résine à base de silicone selon la revendication 1, dans laquelle la composition de résine à base de silicone comprend le polysiloxane organique et la charge conductrice dans un rapport pondéral de 20:80 à 5:95.

**3.** Composition de résine à base de silicone selon la revendication 1, dans laquelle la première poudre conductrice a une densité tassée de 0,1 g/cm$^3$ à 3,0 g/cm$^3$.

**4.** Composition de résine à base de silicone selon la revendication 1, dans laquelle la première poudre conductrice a une surface spécifique de 0,2 m$^2$/g à 5,0 m$^2$/g,

la surface spécifique, environ 2 g de poudre d'argent, est prise comme échantillon, et après dégazage à 60 ± 5 °C pendant 10 minutes, une surface totale est mesurée avec un dispositif de mesure de surface spécifique automatique (procédé BET),
la quantité de l'échantillon est pesée, et la surface spécifique est calculée selon l'équation suivante :

surface spécifique (m$^2$/g) = surface totale (m$^2$)/quantité d'échantillon (g).

**5.** Composition de résine à base de silicone selon la revendication 1, dans laquelle la composition de résine à base de silicone a une conductivité thermique par poids de charge de 1 W/mK ou plus calculée par l'équation 3 ci-dessous :

[Équation 3]

$$X/Y \times 10$$

où X est une conductivité thermique, mesurée à 25 °C, du premier échantillon de feuille ou du second échantillon de feuille, et Y est un % en poids de la charge conductrice par rapport au poids total de la composition de résine à base de silicone.

**6.** Composition de résine à base de silicone selon la revendication 2, dans laquelle le premier échantillon de feuille ou le

second échantillon de feuille a une conductivité thermique de 10 W/mK ou plus mesurée à 25 °C.

**7.** Dispositif semi-conducteur, comprenant :

un boîtier semi-conducteur ;
une partie de dissipation thermique disposée sur le boîtier semi-conducteur ; et
une couche de conduction thermique interposée entre le boîtier semi-conducteur et la partie de dissipation thermique,
dans lequel la couche de conduction thermique comprend une composition de résine à base de silicone,
dans lequel la composition de résine à base de silicone comprend un polysiloxane organique et une charge conductrice,
dans lequel la charge conductrice comprend une première poudre conductrice comportant des particules de type dendrite et une deuxième poudre conductrice comprenant des particules sphériques,
dans lequel la première poudre conductrice et la deuxième poudre conductrice sont présentes en un rapport pondéral de 5:95 à 50:50,
dans lequel la première poudre conductrice comprend de la poudre d'argent traitée en surface avec un acide gras en C10 à C20, et
la composition de résine à base de silicone a un taux de variation de conductivité thermique de 30 % ou moins mesuré par le procédé de mesure ci-dessous :
[Procédé de mesure]

1) on moule la composition de résine à base de silicone par presse à chaud pendant 15 minutes dans des conditions de 165 °C et une pression de 26 kgf/cm$^2$ pour fabriquer une première feuille, et séparément, on moule la composition de résine à base de silicone par presse à chaud pendant 15 minutes dans des conditions de 165 °C et une pression de 0,1 kgf/cm$^2$ pour fabriquer une deuxième feuille,
2) on durcit la première feuille et la deuxième feuille à 150 °C pendant 2 heures pour fabriquer respectivement un échantillon de la première feuille et un échantillon de la deuxième feuille,
3) une conductivité thermique du premier échantillon de feuille et une conductivité thermique du second échantillon de feuille sont mesurées à 25 °C selon la norme ISO 22007-2,
4) un taux de variation de conductivité thermique est calculé selon l'équation 2 ci-dessous :

$$\text{taux de variation de conductivité thermique (\%)} = (|TC_{26} - TC_{0,1}|/TC_{26}) \times 100 \quad \text{[Équation 2]}$$

où $TC_{26}$ est une conductivité thermique (W/mK) du premier échantillon de feuille, et $TC_{0,1}$ est une conductivité thermique (W/mK) du second échantillon de feuille.

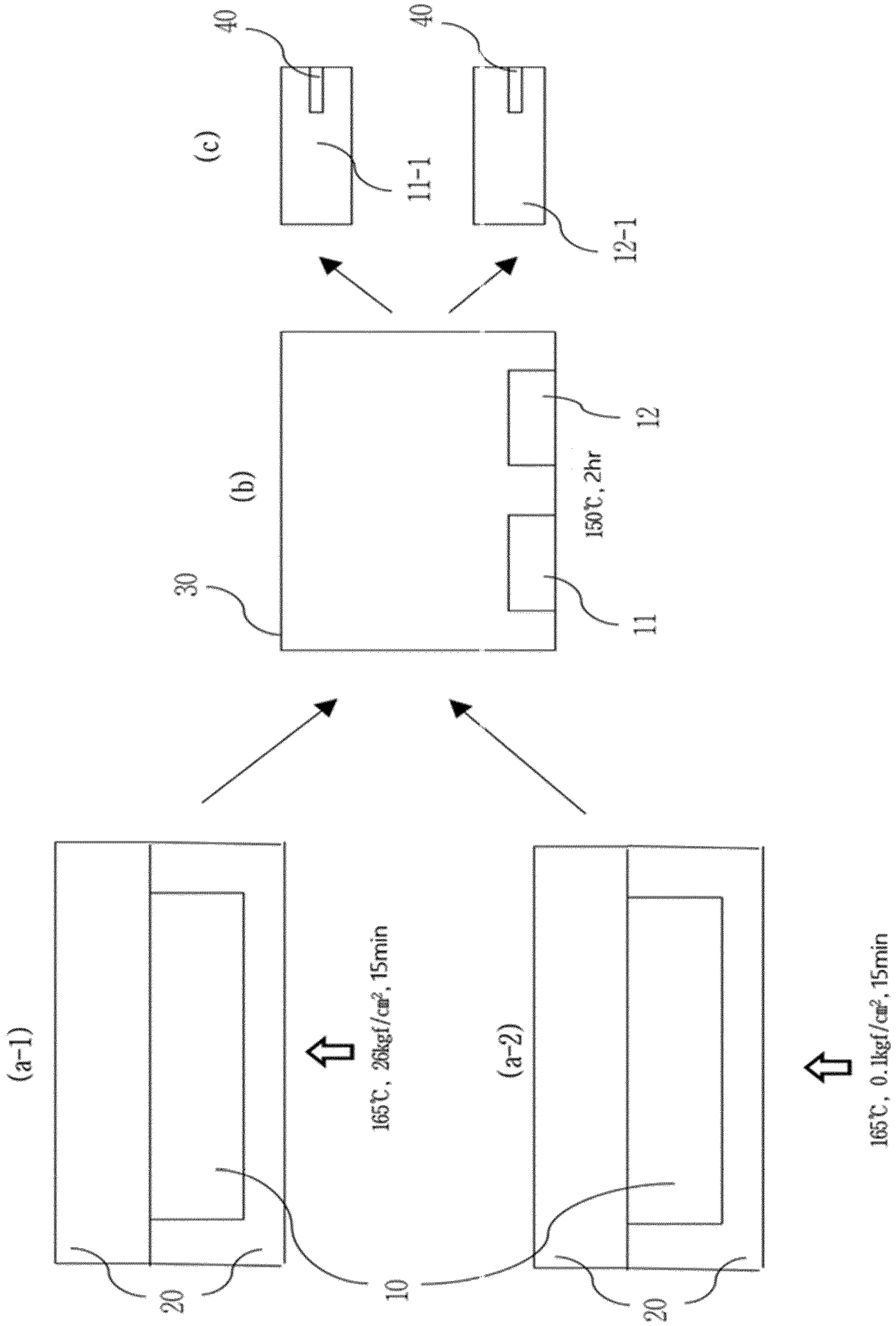
(a-1)
165℃, 26kgf/㎠, 15min
(a-2)
165℃, 0.1kgf/㎠, 15min
20
10
20
(b)
30
150℃, 2hr
11
12
(c)
40
11-1
40
12-1

FIG. 1

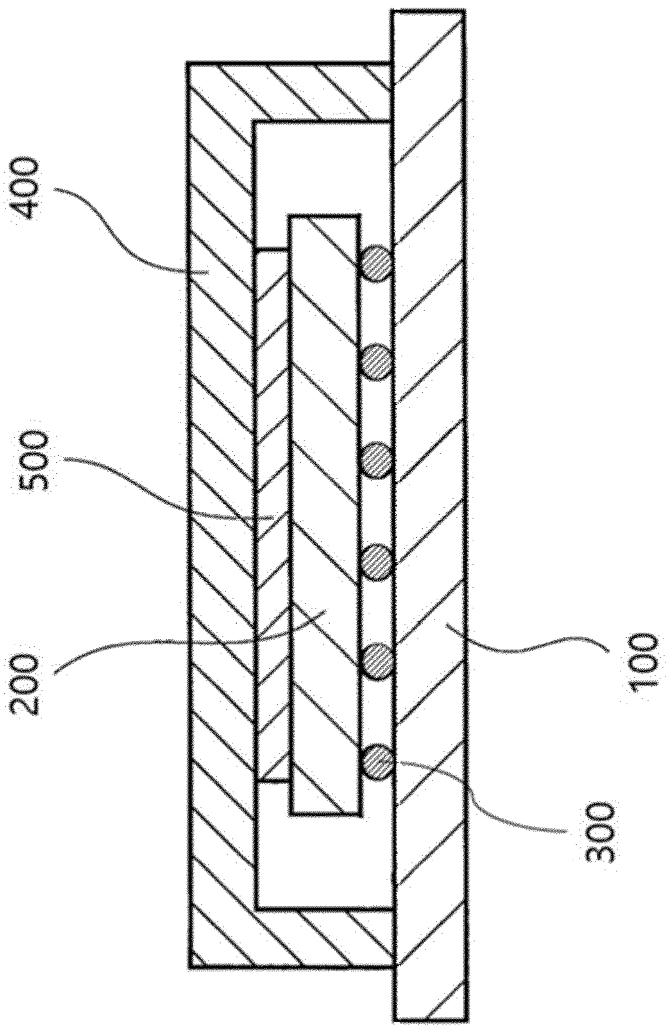


FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*




### Patent documents cited in the description


- KR 1020200086307
- WO 2021142752 A1